# EUROPEAN PATENT APPLICATION

(11) **EP 4 772 957 A1**
(43) Date of publication of application: **08.07.2026**
(21) Application number: 24858082.1
(22) Date of filing: 10.07.2024
(51) Int. Cl.: G06F 1/12

(54) **CLOCK CALIBRATION CIRCUIT**

(30) Priority: 31.08.2023 CN 202311116565
(71) Applicant: Sanechips Technology Co., Ltd., Shenzhen, Guangdong 518055 (CN)
(72) Inventor: LIN, Wenqiong, Shenzhen, Guangdong 518055 (CN); KE, Qiutan, Shenzhen, Guangdong 518055 (CN); HAO, Yingli, Shenzhen, Guangdong 518055 (CN); HUO, Haitao, Shenzhen, Guangdong 518055 (CN)
(74) Representative: Cristinelli, Luca
(86) International application number: PCT/CN2024/104784
(87) International publication number: WO 2025/044538

(57) **Abstract**

Provided is a clock calibration circuit. The circuit includes: a first sampling circuit; and a second sampling circuit in series with the first sampling circuit; the first sampling circuit comprises: a phase-locked loop (PLL); a first duty cycle calibrator (DCC) connected in series with the PLL; a first phase interpolator (PI) connected in series with the first DCC; a first clock tree connected in series with the first PI; a first data serializer connected in series with the first clock tree; a first transmit driver connected in series with the first data serializer; a second data serializer connected in series with the first DCC; and a second transmit driver connected in series with the second data serializer; the PLL is configured to output a clock signal to drive the first data serializer to transmit data to be transmitted to the first transmit driver, and drive the second data serializer to transmit a feedforward clock signal to the second transmit driver; and the second transmit driver is configured to transmit the feedforward clock signal to a first receive driver in the second sampling circuit, to determine the feedforward clock signal as a sampling clock for the second sampling circuit.

## Description

### Cross-Reference to Related Application

This present disclosure claims priority to Chinese Patent Application No. 202311116565.1, filed to the China National Intellectual Property Administration on August 31, 2023 and entitled "Clock calibration circuit", the disclosure of which is hereby incorporated by reference in its entirety.

### Technical Field

The present disclosure relates to the field of communications, and specifically to a clock calibration circuit.

### Background

In the prior art, packaging integration of multiple dies has been widely applied in the semiconductor industry, including mainstream central processing units (CPUs) and general-purpose graphics processing units (GP-GPUs), and the development of small packaged chips is driven by multiple factors. At present, in the field of Chiplet (chiplet interconnect), the main technologies for cross-die (unpacked chip particles) or cross-package sampling clock calibration include: CDR (Clock and Data Recovery) technology commonly used in SerDes (Serializer/Deserializer), which is clock data recovery technology; and clock-forwarding technology employed by AIB, UCle (Universal Chiplet Interconnect Express) and the like, which feeds forward the clock used for transmitting data to the receiving side simultaneously to sample the received data.

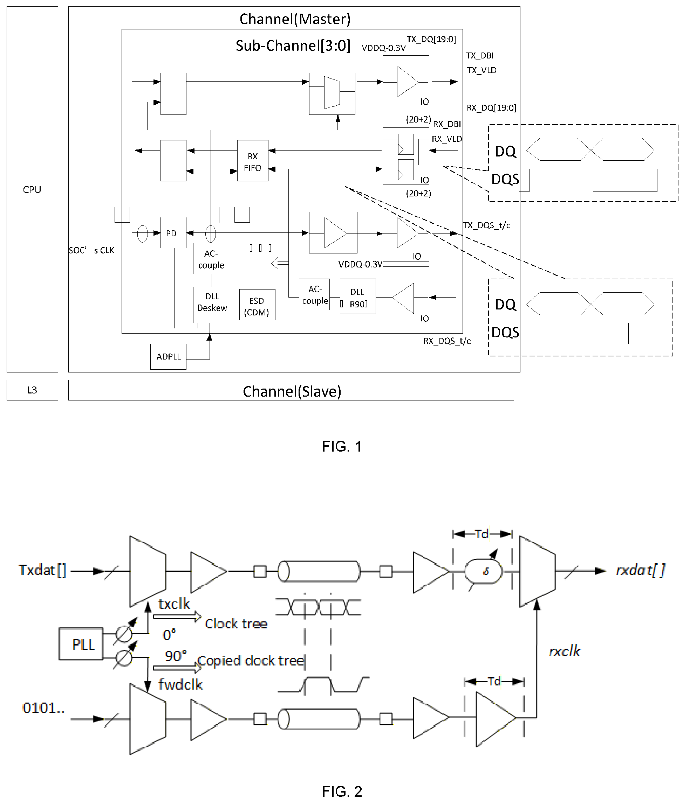

Fig. 1 is a diagram of chiplet sampling in the prior art. As shown in Fig. 1, it is required to align the data clock layout routing at the back end. During DQS sampling to RX, it passes through a DLL (R90) so that the DQS is phase-shifted 90 degrees from IO output to the RX FIFO clock input point, which is exactly in the data center position as shown in Fig. 1. The difficulty in implementing this solution lies in that it needs to ensure that the total delay of DLL plus clock tree equals T/4, and this technology is based on a 4GHz clock, that is, T/4 = 62.5 ps. For a parallel port architecture that drives a plurality of lanes, such as 40 to 64 lanes, the clock tree delay is 70 to 80 ps at the best corner (an optimal process corner: an optimal change range of process parameters) under a 3nm or 5nm process, and more than 120 ps at a worst corner (which refers to the process corner point that causes the clock tree to have the maximum delay).

Fig. 2 is a structural diagram of a transmitting side generating a 90 degree phase shift in the prior art. As shown in Fig. 2, the implementation method in Fig. 2 involves ensuring data-clock alignment on both the TX side and RX side during backend layout. During operation, a 90 degree phase shift may be generated on the transmitting side by detection, and the sampling clock moved to forward to the receiving side is aligned with the center of the data. The implementation solution in Fig. 2 has the following disadvantages: on the transmitting side, the fwdclk (the feedforward clock signal of the transmitting side) needs to replicate the txclk (the clock of the transmitting side) to drive distributed clock trees of a plurality of lanes, so as to ensure that the IO output data txdat of the left circuit is aligned with the fwdclk (after the fwdclk is adjusted by 90 degrees, the edge of the fwdclk is aligned with the data center).

In the clock calibration circuit in the prior art, the clock calibration process of the first sampling circuit at the transmitting side and the second sampling circuit at the receiving side easily causes the problems such as delay deviation in the circuit, for which effective solutions have not been proposed.

Therefore, there is a need for improvements in the related art to overcome the deficiencies in the related art.

### Summary

Embodiments of the present disclosure provide a clock calibration circuit to at least solve the problem in the prior art that a delay deviation in a circuit is easily caused by a clock calibration process of a first sampling circuit at a transmitting side and a second sampling circuit at a receiving side.

According to one aspect of embodiments of the present disclosure, a clock calibration circuit is provided, including: a first sampling circuit; and a second sampling circuit connected in series with the first sampling circuit; where the first sampling circuit includes: a phase-locked loop (PLL); a first duty cycle calibrator (DCC) connected in series with the PLL; a first phase interpolator (PI) connected in series with the first DCC; a first clock tree connected in series with the first PI; a first data serializer connected in series with the first clock tree; a first transmit driver connected in series with the first data serializer; a second data serializer connected in series with the first DCC; and a second transmit driver connected in series with the second data serializer; where the PLL is configured to output a clock signal to drive the first data serializer to transmit data to be transmitted to the first transmit driver, and drive the second data serializer to transmit a feedforward clock signal to the second transmit driver; and the second transmit driver is configured to transmit the feedforward clock signal to a first receive driver in the second sampling circuit, to determine the feedforward clock signal as a sampling clock for the second sampling circuit.

In an exemplary embodiment, the second sampling circuit includes: a second receive driver connected in series with the first transmit driver and configured to receive the data to be transmitted from the first transmit driver, and transmit the data to be transmitted to a first data deserializer through a small delay buffer connected in series with the second receive driver, where the first data deserializer is connected in series with the small delay buffer.

In an exemplary embodiment, the second sampling circuit further includes: a DCC buffer; where the DCC buffer is connected in series with the second receive driver and the small delay buffer respectively, and is configured to compensate for an intrinsic delay of the first DCC.

In an exemplary embodiment, the second sampling circuit includes: a second DCC connected in series with the first receive driver; a second PI connected in series with the second DCC; a second clock tree connected in series with the second PI; and the first data deserializer and a second data deserializer both connected in series with the second clock tree; where the first receive driver is configured to transmit the feedforward clock signal to the first data deserializer and the second data deserializer respectively through the second DCC, the second PI and the second clock tree, so as to determine the feedforward clock signal as a sampling clock for the first data deserializer and the second data deserializer.

In an exemplary embodiment, the second sampling circuit includes: a PI buffer; where the PI buffer is connected in series with the second clock tree and the first data deserializer respectively, and is configured to compensate for an intrinsic delay of the second PI.

In an exemplary embodiment, the second sampling circuit includes: a third PI connected in series with the second clock tree, and a second data deserializer connected in series with the third PI; where the third PI is configured to be set to a fixed phase shift after training of a plurality of data links and TRACK links is completed, where the plurality of the data links and the TRACK links correspond to different transmit drivers respectively.

In an exemplary embodiment, the first sampling circuit includes: a third PI, connected in series with the first clock tree and the first data serializer respectively, and configured to be set to a fixed phase shift after training of a plurality of data links and TRACK links is completed, where the plurality of the data links and the TRACK links correspond to different transmit drivers respectively.

In an exemplary embodiment, the second sampling circuit includes: a first data check module, connected in series with the first data deserializer and the second PI respectively, and configured to adjust a delay of the second PI during training of data links; and/or a second data check module, connected in series with the second data deserializer and the second PI respectively, and configured to adjust a delay of the second PI during training of TRACK links.

In an exemplary embodiment, the second sampling circuit includes: a first delay-locked loop (DLL) connected in series with the second clock tree and the first data deserializer respectively; the second sampling circuit further includes: a second DLL connected in series with the second clock tree and the second data deserializer respectively.

In an exemplary embodiment, the second sampling circuit includes: a third DLL, connected in series with the second DCC and the second PI respectively, and configured to perform delay processing on a plurality of data links and TRACK links, where the plurality of the data links and the TRACK links correspond to different transmit drivers respectively.

By means of the present disclosure, a clock calibration circuit includes: a first sampling circuit; and a second sampling circuit in series with the first sampling circuit; where the first sampling circuit comprises: a phase-locked loop (PLL); a first duty cycle calibrator (DCC) connected in series with the PLL; a first phase interpolator (PI) connected in series with the first DCC; a first clock tree connected in series with the first PI; a first data serializer connected in series with the first clock tree; a first transmit driver connected in series with the first data serializer; a second data serializer connected in series with the first DCC; and a second transmit driver connected in series with the second data serializer; where the PLL is configured to output a clock signal to drive the first data serializer to transmit data to be transmitted to the first transmit driver, and drive the second data serializer to transmit a feedforward clock signal to the second transmit driver; and the second transmit driver is configured to transmit the feedforward clock signal to a first receive driver in the second sampling circuit, to determine the feedforward clock signal as a sampling clock for the second sampling circuit. This solves the problems such as delay deviation in the circuit easily caused by the clock calibration process of the first sampling circuit at the transmitting side and the second sampling circuit at the receiving side in the prior art. In addition, the second sampling circuit on the receiving side may perform clock calibration according to the feedforward clock signal transmitted by the first sampling circuit, avoiding the problem in the prior art that a delay deviation in a circuit is easily caused during a clock calibration process of a first sampling circuit at a transmitting side and a second sampling circuit at a receiving side.

The present disclosure does not need to add a compensation delay device in a receive data path to align the sampling clock, thereby solving the problem of signal degradation caused by the compensation delay device in a data path under a high-speed signal.

### Brief Description of the Drawings

The drawings described herein are intended to provide further understanding of the present disclosure, and form a part of the present disclosure. The exemplary embodiments of the present disclosure and the description thereof are used to explain the present disclosure, and do not form improper limits to the present disclosure. In the drawings:
Fig. 1 is a schematic diagram of chiplet sampling in the prior art;
Fig. 2 is a schematic structural diagram of a transmitting side generating a 90 degree phase shift in the prior art;
Fig. 3 is an overall circuit diagram of a clock calibration circuit according to an embodiment of the present disclosure;
Fig. 4 is an overall circuit diagram of a clock calibration circuit according to an embodiment of the present disclosure;
Fig. 5 is a block diagram of PI logic according to an embodiment of the present disclosure;
Fig. 6 is an optional calibration process diagram according to an embodiment of the present disclosure;
Fig. 7 is a schematic diagram of eye pattern alignment according to an embodiment of the present disclosure;
Fig. 8 is a diagram of TRACK data boundary alignment with clock edge according to an embodiment of the present disclosure;
Fig. 9 is a diagram of a sampling clock drifting to the right according to an embodiment of the present disclosure;
Fig. 10 is a circuit diagram of a clock calibration circuit according to an embodiment of the present disclosure;
Fig. 11 is another circuit diagram of a clock calibration circuit according to an embodiment of the present disclosure.

### Detailed Description of the Embodiments

In order to make persons skilled in the art better understand the solutions of the present disclosure, the following clearly and completely describes the technical solutions in the embodiments of the present disclosure with reference to the accompanying drawings in the embodiments of the present disclosure. Apparently, the described embodiments are merely a part rather than all of the embodiments of the present disclosure. All other embodiments obtained by persons of ordinary skill in the art based on the embodiments of the present disclosure without creative efforts shall belong to the scope of protection of the present disclosure.

It should be noted that, terms such as "first" and "second" in the description, claims, and accompanying drawings of the present disclosure are used to distinguish similar objects, but are not necessarily used to describe a specific sequence or order. It should be understood that the data so used may be interchanged where appropriate so that embodiments of the present disclosure described herein may be implemented in sequences other than those illustrated or described herein. In addition, the terms "include" and "have", and any variations thereof, are intended to cover a non-exclusive inclusion, for example, a process, method, system, product, or apparatus that includes a series of steps or units is not necessarily limited to those steps or units that are expressly listed, but may include other steps or units that are not expressly listed or inherent to such process, method, product, or apparatus.

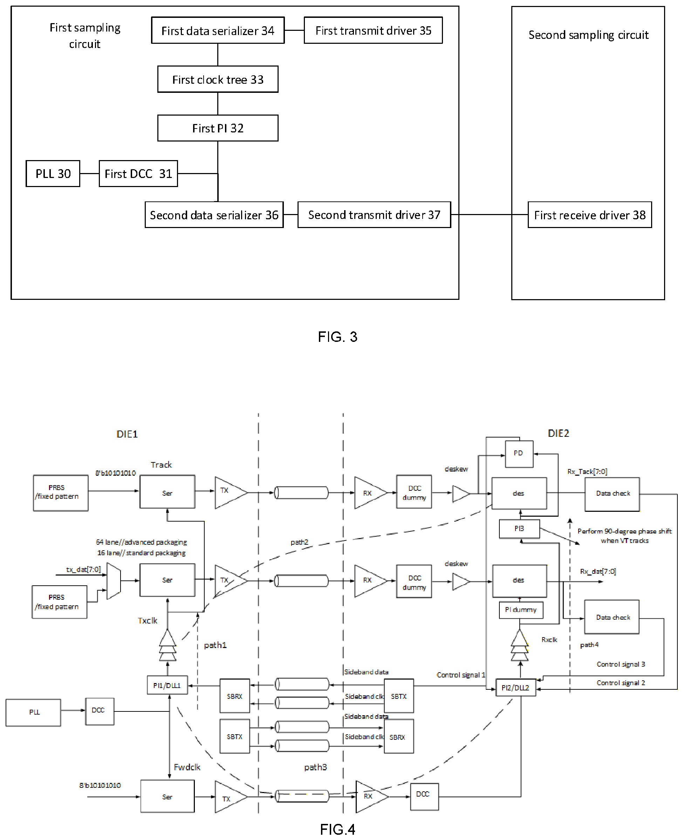

Fig. 3 is an overall circuit diagram of a clock calibration circuit according to an embodiment of the present disclosure. As shown in Fig. 3, the clock calibration circuit includes:
A first sampling circuit; and a second sampling circuit connected in series with the first sampling circuit;
where the first sampling circuit includes: a phase-locked loop PLL 30; a first duty cycle calibrator DCC 31 connected in series with the PLL; a first phase interpolator PI 32 connected in series with the first DCC 31; a first clock tree 33 connected in series with the first PI 32; a first data serializer 34 connected in series with the first clock tree 33; a first transmit driver 35 connected in series with the first data serializer 34; a second data serializer 36 connected in series with the first DCC 31; and a second transmit driver 37 connected in series with the second data serializer 36;
where the PLL 30 is configured to output a clock signal to drive the first data serializer 34 to transmit data to be transmitted to the first transmit driver 35, and to drive the second data serializer 36 to transmit a feedforward clock signal to the second transmit driver 37;
the second transmit driver 37 is configured to transmit the feedforward clock signal to the first receive driver 38 in the second sampling circuit, to determine the feedforward clock signal as the sampling clock for the second sampling circuit.

Embodiments of the present disclosure provide a clock calibration circuit, including: a first sampling circuit; and a second sampling circuit in series with the first sampling circuit; where the first sampling circuit comprises: a phase-locked loop (PLL); a first duty cycle calibrator (DCC) connected in series with the PLL; a first phase interpolator (PI) connected in series with the first DCC; a first clock tree connected in series with the first PI; a first data serializer connected in series with the first clock tree; a first transmit driver connected in series with the first data serializer; a second data serializer connected in series with the first DCC; and a second transmit driver connected in series with the second data serializer; where the PLL is configured to output a clock signal to drive the first data serializer to transmit data to be transmitted to the first transmit driver, and drive the second data serializer to transmit a feedforward clock signal to the second transmit driver; and the second transmit driver is configured to transmit the feedforward clock signal to a first receive driver in the second sampling circuit, to determine the feedforward clock signal as a sampling clock for the second sampling circuit. This solves the problems such as delay deviation in the circuit easily caused by the clock calibration process of the first sampling circuit at the transmitting side and the second sampling circuit at the receiving side in the prior art. In addition, the second sampling circuit on the receiving side may perform clock calibration according to the feedforward clock signal transmitted by the first sampling circuit, avoiding the problem in the prior art that a delay deviation in a circuit is easily caused during a clock calibration process of a first sampling circuit at a transmitting side and a second sampling circuit at a receiving side.

In an exemplary embodiment, the second sampling circuit includes: a second receive driver connected in series with the first transmit driver and configured to receive the data to be transmitted from the first transmit driver, and transmit the data to be transmitted to a first data deserializer through a small delay buffer connected in series with the second receive driver, where the first data deserializer is connected in series with the small delay buffer.

It can be understood that, the second receive driver is configured to receive the data to be transmitted by the first transmit driver in the first sampling circuit, and the second receive driver transmits the data to be transmitted to the first data deserializer by using a small delay buffer when receiving the data to be transmitted. That is to say, the transmission path of the data to be transmitted is from the first transmit driver to the second receive driver, and then to the first data deserializer via a small-delay buffer.

In an exemplary embodiment, the second sampling circuit further includes: a DCC buffer; where the DCC buffer is connected in series with the second receive driver and the small delay buffer respectively, and is configured to compensate for an intrinsic delay of the first DCC.

It can be understood that, in the above circuit, the DCC buffer is connected in series with the second receive driver and the small delay buffer respectively, and the DCC buffer can be used for compensating an intrinsic delay of the first DCC in the circuit, that is to say, the DCC buffer is used for compensating an inherent delay of the DCC in the above circuit, i.e. the time that data to be transmitted passes through the DCC from the input to the output.

In an exemplary embodiment, the second sampling circuit includes: a second DCC connected in series with the first receive driver; a second PI connected in series with the second DCC; a second clock tree connected in series with the second PI; and the first data deserializer and a second data deserializer both connected in series with the second clock tree; where the first receive driver is configured to transmit the feedforward clock signal to the first data deserializer and the second data deserializer respectively through the second DCC, the second PI and the second clock tree, so as to determine the feedforward clock signal as a sampling clock for the first data deserializer and the second data deserializer.

It can be understood that the second sampling circuit is formed by connecting a second DCC, a second PI, a second clock tree, a first data deserializer, a second data deserializer, and so on, where the feedforward clock signal is transmitted to the first data deserializer and the second data deserializer via the second DCC, the second PI and the second clock tree, respectively, The aim is to determine the feedforward clock signal as the sampling clock of the first data deserializer and of the second data deserializer.

In an exemplary embodiment, the second sampling circuit includes: a PI buffer; where the PI buffer is connected in series with the second clock tree and the first data deserializer respectively, and is configured to compensate for an intrinsic delay of the second PI.

It can be understood that, in the above circuit, the PI buffer is connected in series with the second clock tree and the first data deserializer respectively, and the PI buffer can be used for compensating the intrinsic delay of the second PI in the circuit, that is to say, the PI buffer is used for compensating the intrinsic delay of the second PI in the above circuit, i.e. the time for the data to be transmitted to pass through the second PI from the input to the output.

In an exemplary embodiment, the second sampling circuit includes: a third PI connected in series with the second clock tree, and a second data deserializer connected in series with the third PI; where the third PI is configured to be set to a fixed phase shift after training of a plurality of data links and TRACK links is completed, where the plurality of the data links and the TRACK links (which is basically consistent with the plurality of data lanes, and can be taken as a representative of delay of a data path) correspond to different transmit drivers respectively.

It can be understood that the second sampling circuit further includes a third PI and a second data deserializer, where the third PI can be set to be a fixed phase shift after training of a plurality of data links and TRACK links is completed.

In an exemplary embodiment, the first sampling circuit includes: a third PI, connected in series with the first clock tree and the first data serializer respectively, and configured to be set to a fixed phase shift after training of a plurality of data links and TRACK links is completed, where the plurality of the data links and the TRACK links correspond to different transmit drivers respectively.

In an exemplary embodiment, the second sampling circuit includes: a first data check module, connected in series with the first data deserializer and the second PI respectively, and configured to adjust a delay of the second PI during training of data links; and/or a second data check module, connected in series with the second data deserializer and the second PI respectively, and configured to adjust a delay of the second PI during training of TRACK links.

It may be understood that, the second sampling circuit further includes: a first data check module and/or a second data check module, which may be configured to adjust the delay of the second PI during training of the data links and/or training of the TRACK links.

In an exemplary embodiment, the second sampling circuit includes: a first delay-locked loop (DLL) connected in series with the second clock tree and the first data deserializer respectively; the second sampling circuit further includes: a second DLL connected in series with the second clock tree and the second data deserializer respectively.

It can be understood that, the second sampling circuit further includes a first delay phase locked loop DLL and a second DLL.

In an exemplary embodiment, the second sampling circuit includes: a third DLL, connected in series with the second DCC and the second PI respectively, and configured to perform delay processing on a plurality of data links and TRACK links, where the plurality of the data links and the TRACK links correspond to different transmit drivers respectively.

It can be understood that the second sampling circuit further includes: a third DLL, configured to delay processing signals of the data link and the TRACK link, and capable of generating a corresponding delay signal according to an input reference clock signal and control signal, so as to realize delay control on the signals of the data links and the TRACK links.

The second DCC can control the delay amount of the third DLL, and can adjust the delay amount of the third DLL according to the input control signal, thereby realizing accurate control of signal delay of the data link and the TRACK link.

In order to better understand the process of the described clock calibration circuit, the implementation flow of the described clock calibration circuit will be described below in combination with an optional embodiment, but is not used to limit the technical solution of the embodiments of the present disclosure.

The clock calibration circuit will be further described in combination with the following embodiments.

Embodiments of the present disclosure relate to a cross-die sampling clock calibration method, and in particular, to a cross-die sampling clock calibration technology in the field of Chiplets.

In the field of Chiplets, cross-die or cross-package sampling clock calibration technology is one of key technologies. At present, in the field of Chiplets, the main technologies for cross-die or cross-package sampling clock calibration include CDR technology commonly used in SerDes, which is clock data recovery technology; AIB, UCle and the like use clock-forwarding technology, in which the clock used for transmitting data is forwarded to the receiving side simultaneously to sample the received data.

The embodiments of the present disclosure adopt clock-forwarding technology. The clock-forwarding technology is widely applied in digital circuits, and is used for solving the problems of propagation delay and clock jitter of clock signals in circuits. **In** digital systems, clock signals are used to synchronize the operations of the various components to ensure that they operate at the correct time. However, when the clock signal propagates in the circuit, the clock signal may experience jitter or delay due to factors such as delay and noise in the circuit, thereby affecting stability and performance of the system.

The clock-forwarding technology introduces an additional delay path in the circuit, allowing the clock signal to reach the target component in advance, thereby offsetting propagation delay and reducing jitter. It is based on the principle that the propagation speed of the clock signal is faster than that of the data signal; during the propagation of the clock signal, the clock signal is transferred to reach in advance the target component requiring synchronization, so as to ensure that the target component can receive the clock signal at a correct time.

The clock-forwarding technology can improve the reliability and performance of digital systems, reduce the influence of clock jitter on the operations of circuits, and enable the system to operate more stably. It is widely applied to fields such as high-speed digital circuits, time sequence circuits, and synchronous circuits.

One of the main functions involved in clock-forwarding technology is sampling clock calibration, which is described in detail as follows:
The forward clock is calibrated to be aligned at the center of the received data, and can follow the drift of the voltage temperature in operation, thereby satisfying the width requirements of the UCle eye pattern.

As shown in Figs. 1 and 2, methods for aligning an output clock and data of the transmitting side are provided. In one of the methods, a sampling clock with a 90 degree phase shift is directly generated at the receiving side, and the difficulty lies in that a clock tree at the receiving side is not easy to shorten, and the clock frequency cannot reach 8 GHz required by UCle; in the other of the methods, the clock and the data are aligned at both the transmitting side and the receiving side, and a copied clock tree and data pad delay are used to compensate for the clock at the receiving side, of which the disadvantage is that it adds significant delay, increases power consumption, and results in large delay skew, failing to reach the eye width standard required by UCle.

The clock tree refers to a tree structure used for transmitting and distributing clock signals in synchronous circuits. In digital circuit design, clock signals are used to synchronize operations of individual logic gates, ensuring that they operate within the correct time intervals. The design of the clock tree aims to ensure that the clock signal can be accurately and stably delivered to each logic gate, so as to guarantee the correct operation of the circuit.

Fig. 4 is an overall circuit diagram of a clock calibration circuit according to an embodiment of the present disclosure. As shown in Fig. 4:
PLL: abbreviation for Phase-Locked Loop, refers to a phase-locked loop;
DLL: abbreviation for Delay-Locked Loop, refers to a delay-locked loop;
DCC: abbreviation for Duty Cycle Calibrator, whose precision requirement is determined according to the specific implementation frequency, typically requiring -0.02 UI~0.02 UI;
DCC dummy: a buffer for compensating the intrinsic delay of the DCC, typically with delay less than 10 ps;
Ser: abbreviation for Serializer, refers to a data serializer;
Des: abbreviation for De-Serializer, refers to a data deserializer;
PI: abbreviation for Phase interpolator, refers to a phase interpolator;
PI dummy: a buffer to compensate for the intrinsic delay of the PI, with the intrinsic delay less than or equal to 2 ps;
TX: refers to a transmit driver;
RX: means a receiver;
PD: abbreviation for Phase Detector, refers to a phase detector;
Deskew: an adjustable small delay line, approximately = 0.04 UI (maximum delay at 8 Gbps is 5 ps);
SBTX: abbreviation for SideBand TX, refers to a sideband transmitter, with working frequency being generally 800 MHz;
SBRX: abbreviation for SideBand RX, refers to a sideband receiver, with working frequency being generally 800 MHz; (note: sideband data communication does not require calibration; the SBTX transmits data on falling edges, and the SBRX samples on rising edges);
TRACK: the circuit implementation is substantially identical to that of multiple data lanes, and can serve as a representative of data path delay. Unlike the data lanes, the des module clock input of the TRACK has PI3 which implements a 90-degree phase shift on the sampling clock.

Further, the PLL output clock passes through the DCC (Duty Cycle Calibrator), then passes through the phase interpolator PI1, and is distributed through clock tree to drive the ser modules of multiple data lanes(parallel-to-serial conversion) to transmit data to the TX (transmit driver); the ser module driving the TRACK lane transmits fixed pattern data to the TX. The ser module of the fwdclk lane is driven by the clock passing through the DCC to transmit fwdclk to the TX as the sampling clock for the peer die. The delay between the fwdclk path and the data transmission path does not need to be consistent.

On the receiving side, the data lane (equivalent to the link in the foregoing embodiments) and the TRACK lane pass through the RX (receiver), then through the DCC dummy (DCC intrinsic delay compensation buffer), and then through the deskew (adjustable small-delay buffer to align deviations among data lanes) to reach the des (deserializer). The fwdclk is received by the RX, then passes through the DCC and then the distributed clock tree to reach the des modules of each data lane and TRACK lane as sampling clock inputs. The receive data path does not require additional delay to align with the sampling clock.

The DCC dummy and the PI dummy in Fig. 4 are buffers for compensating for the intrinsic delays of the DCC and the PI.

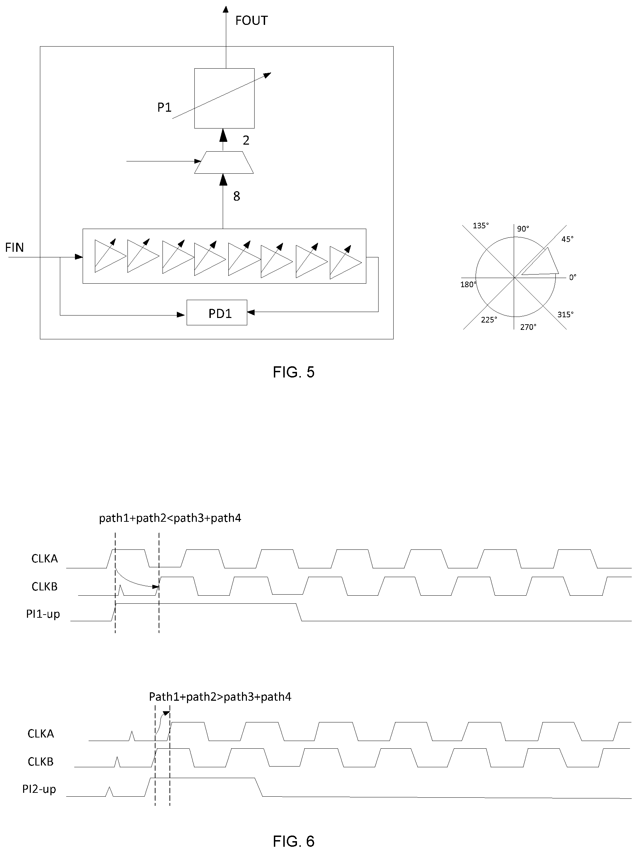

Fig. 5 is a block diagram of PI logic according to an embodiment of the present disclosure. As shown in Fig. 5, the PI has an 8-phase tap output. Since a 360-degree phase detector tracks VT and maintains synchronization with the cycle, phase delays of the 8 phases maintain a ratio relative to 360 degrees, and thus the 8-phase output clock is compensated with VT tracking.

When 8:2, the 90-degree and 135-degree phase outputs are selected, PI=0, and the FOUT output is a FIN clock with a 90-degree phase shift.

It should be noted that this is only an example based on the embodiments of the present disclosure and is not limited to using this structure. For example, PI1 and PI2 in the embodiment may also be replaced by DLL1 and DLL2.

As shown in Figs. 4 and 5, on the transmitting side, the input of the data lane is: PRBS (Pseudo-Random Binary Sequence) pseudo-random sequence/fixed pattern and tx_dat (normal data of upper layer); the input to the TRACK lane is: PRBS pseudo-random sequence/fixed pattern; the PRBS pseudo-random sequence/fixed pattern is used for initialization training.

The transmitting-side transmitting clock tree is connected to PI1, the receiving-side sampling clock tree is connected to PI2, and after passing through the clock tree, the sampling clock is connected to PI3 and then to the des module clock input of the TRACK lane. PI1 and PI2 are variable delay lines used during training or VT tracking. PI3 initially only has intrinsic delay. Before normal operation after training of the data lane and the TRACK lane is completed, PI3 needs to be set to a fixed 90-degree phase shift so as to ensure that the sampling clock is located at the right boundary of the TRACK data.

On the receiving side, the PD phase detector is located at the data input and the sampling clock input of the des module of the TRACK lane, and phase-locking is performed on the clock on the TRACK and the fwdclk clock during initialization. Because the TRACK is basically equivalent to one of the data lanes, locking the TRACK and the fwdclk clocks is equivalent to locking the delay between the data lane and the fwdclk clocks. The PD output reaches the transmitting side via the sideband to adjust the delay of the PI1, or directly adjusts the delay value of the PI2 on the local side.

The data check module on the data lane is configured to adjust the PI2 delay value during training of the data lane; the data check module on the TRACK lane is configured to adjust the PI2 delay during training of the data lane, and to track the VT to adjust PI2 delay during normal operation.

It should be noted that, during the back-end implementation of any optional embodiment of the present disclosure, the following requirements should be met: 1) the delay deviation between path2 and path3 should be minimized (for example, for UCIe, it is <0.14 UI, where UI is a data width, typically period/2 of the txclk); 2) the delay deviation among multiple data lanes and multiple Path2 of the TRACK lanes should be minimized (<0.04 UI according to the requirement of the UCle); 3) path1 and path4 are located on different dies, involving different processes and different corners, so the requirement for deviation is relatively loose, generally <0.5 Ul; however, the clock tree should be made as short as possible, and the deviation between the two clock trees should be minimized, so as to reduce the delay variation amount caused by VT changes;

It should be noted that, in the embodiments of the present disclosure, the initialized calibration of path1+path2=path3+path4 is performed after the power-on reset. In this case, throughout the entire link, the deskew buffer (a buffer used to correct the signal delay) has only intrinsic delay, generally ~1 ps. The phase-detection calibration of path1+path2 = path3+path4 is performed through the PD at die2. If path1+path2 is short, increase PI1; otherwise, increase PI2. AT this stage, PI3 has only intrinsic delay. The control signal 1 output by the PD on the Die2 may directly adjust the local PI2, or be transmitted to the Die1 through a sideband signal to adjust the PI1. The implementation method of the sideband is not limited. The step size of delay adjustment is determined by the selected algorithm. The step size varies at different stages in the adjustment process: the initial step size is large, and subsequently, as the two clock edges get closer, the step size should gradually decrease. This step is repeated multiple times until locking is completed when the error between the clock and the TRACK edge reaches a certain value according to an algorithm. At this point, the clock is edge-aligned with the data path within a certain error margin.

Fig. 6 is a diagram of a calibration process of Path1+path2=path3+path4 according to an embodiment of the present disclosure. As shown in Fig. 6, CLKA represents the TRACK signal, and CLKB represents the fwdclk. A control signal 1 with multiple bits is generated according to the Pl1-up and the PI2-up, and is transmitted to the PI1 and the PI2 respectively to adjust their delays. For PI1, the signal needs to pass through the sideband.

In an optional embodiment of the present disclosure, the PD output for Die2 is disconnected, and PI2 scans the eye width separately for each data lane and TRACK lane based on Step 4, and finds the respective midpoint position. Specifically, on die1, random data or fixed pattern data is used to drive a certain data lane or TRACK, and on die2 receiving side, the PI values are recorded by testing based on comparison results of different PIs. A series of data is recorded in ascending order, and the midpoint value is determined. Each lane is tested one by one (including TRACK lanes) to obtain a series of PI midpoint values.

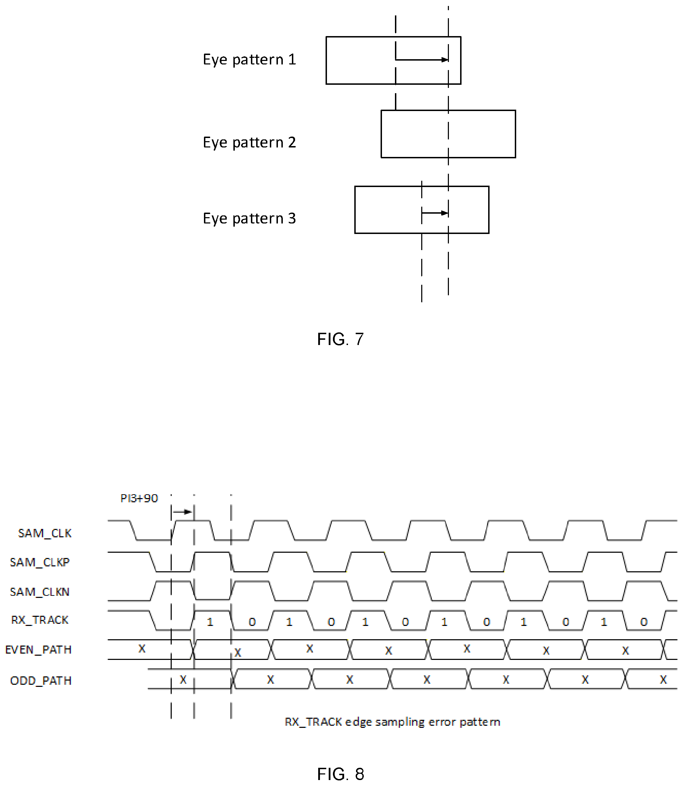

Based on the PI midpoint values obtained for each lane by the described method, the maximum PI midpoint value is taken as a reference, the deskew of the lane with the maximum PI midpoint value remains unchanged, and the deskew of each of other lanes is adjusted as maximum PI midpoint value minus the PI midpoint value of the lane to be adjusted. After adjustment for each lane is completed, the test is performed again to ensure that the received data is right. Fig. 7 is a schematic diagram of eye pattern alignment according to an embodiment of the present disclosure.

In an optional embodiment of the present disclosure, a fixed 90-degree phase shift is applied to the PI3 at the clock input of the des on the Track Plane, shifting the sampling clock from aligning with the data center to aligning with the right boundary, thereby preventing stable data sampling. Fig. 8 is a diagram of TRACK data boundary alignment with clock edge according to an embodiment of the present disclosure. As shown in Fig. 8, the data is normal.

In Fig. 8, SAM_CLK refers to the sampling clock before PI3, which also aligns centers of the eye patterns of all data lanes and TRACK lanes. SAM_CLKP is the clock obtained by applying a 90-degree phase shift to SAM_CLK via the PI3 to sample TRACK, and SAM_CLKN is the reverse clock of SAM_CLKP. SAM_CLKP and SAM_CLKN are two-phase sampling clocks in the DDR mode.

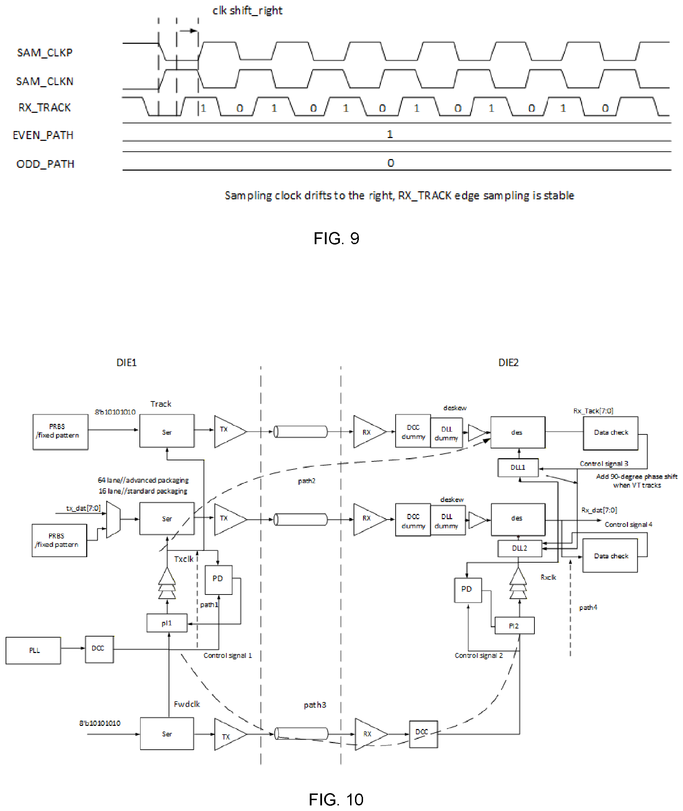

Fig. 9 is a diagram of a sampling clock drifting to the right according to an embodiment of the present disclosure. As shown in Fig. 9, when the sampling clock drifts to the right, the sample of the even path stably equals 1, and the sample of the odd path stably equals 0. The PI2 can be controlled to reduce delay until the RX_TRACK data is as shown in Fig. 8, indicating that the clock offset has been compensated for by tracking.

When the sampling clock drifts to the left, the sample of the even path stably equals 0, and the sample of the odd path stably equals 1. The PI2 can be controlled to increase delay until the RX_TRACK data is as shown in Fig. 8, indicating that the clock drift has been compensated for by tracking.

The step size for controlling PI2 to decrease or increase delay is determined by a selected algorithm.

It should be noted that, relative to the data path, the clock drift is not necessarily caused by delay variation of the clock path, and may actually be caused by data path drift, or both paths may have a drift.

In another optional embodiment, Fig. 10 is a circuit diagram of a clock calibration circuit according to an embodiment of the present disclosure. As shown in Fig. 10, an implementation solution is as follows:
1. Initial calibration of Path1 + path2 = path3 + path4 is no longer performed. Initially, path1 and path4 are separately phase-locked to 1 UI (or 2 UI, 3 UI, or 4 UI), depending on the designed data rate. Taking 16 Gbps as an example, 1 UI = 62.5 ps, and the clock tree is usually 70 ps-120 ps, so setting path1 path4 to be phase-locked to 2 UI is more appropriate.
2. The Track lane has one DLL1, each of the plurality of data lanes has one DLL2 (only one DLL2 is drawn for one data lane in Fig. 10), the maximum delay of the DLL2 needs to be greater than 1 UI, and the maximum delay of the DLL1 needs to be greater than 1.5 UI.
3. A DLL dummy is added on each data lane and TRACK lane, and its function is to compensate for an intrinsic delay of the DLL1 or the DLL2.

The implementation steps in Fig. 10 are different from those in Fig. 4 as follows:
1. The initial calibration of path1+path2=path3+path4 after power-on reset in the above described steps can be changed to: when starting operation, deskew=inherent delay of the DLL2, and calibrate path1 and path4. Through PD phase detector on their respective dies, path1 and path4 are locked onto the 2 UI (or another integer UI, depending on the different data_rates). After locking, the data path is substantially aligned with the clock path and the UCle specification allows a maximum deviation of 0.14 UI.
2. The step of disconnecting the PD output for Die2 can be changed to: calibrating for the TRACK and each data lane separately, one lane at a time. The calibration method is: die1 transmits PRBS data or fixed pattern data, DLL1 and DLL2 on a receiving path on die2 are adjusted, a series of DLL delays with correct detection data are obtained, and the midpoint value is found.
3. For the above steps, obtaining PI midpoint values of each lane based on the foregoing solution can be changed to: finding the maximum among midpoint values of multiple data lanes and TRACK lanes, and adjusting, based on this value, deskews of other lanes so that the delay equals the maximum DLL midpoint value minus the DLL midpoint value of the lane to be adjusted. After each lane is adjusted, the test is performed again to ensure that the received data is right.
4. The step, for Fig. 4, of applying a fixed 90-degree phase shift on the PI3 at the clock input of the des on the Track Lane is corresponding to the step, for Fig. 10, of increasing the delay of DLL1 at the clock input of the des on the Track Lane to shift the sampling clock from aligning with the data center to aligning with the right boundary, thereby preventing stable data sampling. When the TRACK lane detects stable data sampling, the DLL1 scans the eye pattern of the TRACK to find the delay of the DLL1 at the center of the eye pattern. Then the respective DLL2 of each other data lane is adjusted to the delay of the DLL1. Because DLL1 and DLL2 are different instantiations of the same device, they can maintain high consistency. Finally, the delay of the DLL2 is increased until the sampling clock prevents stable data sampling on the TRACK.

DLL1 and DLL2 support a minimum data rate, for example, of 8 Gbps, where 1 Ul=125 ps. Therefore, the maximum delay of the DLL2 is designed to be 128 ps, sufficient to scan the eye width. It has16 coarse-tuning levels and 8 fine-tuning levels, where one of the coarse-tuning levels is slightly greater than the 8 fine-tuning levels, and each of the fine-tuning levels has a delay of 1 ps. DLL1 requires 128+64 = 192 ps, with 24 levels of coarse tuning and a scan range of 0~1.5 UI.

It should be noted that, if the minimum data rate of 4 Gbps needs to be supported, the DLL2 requires the maximum delay of 256 ps, resulting in larger power consumption and area.

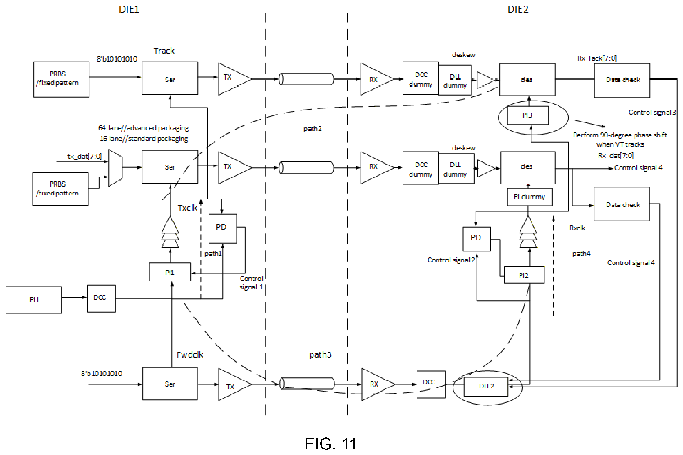

2) Fig. 11 is another circuit diagram of a clock calibration circuit according to an embodiment of the present disclosure. The difference between the implementation solution as shown in Fig. 11 and the solution in Fig. 10 as described above lies in that:
1. The DLL2 is shared by multiple data lanes and TRACK lanes, with a maximum delay greater than 1 UI, thereby reducing the area and power consumption;
2. The DLL1 connected to the clock input of the des in the Track lane is replaced with P13, and the 90-degree phase shift generated by the PI during the VT tracking is locked with VT-following, achieving better tracking precision. Because the sampling clock drift output by the DLL1 in alternative solution 1 is caused by the delay of the DLL1's delay unit changing with VT (Voltage and Temperature), the same change of the DLL2 is required, and the difference between the two will affect the tracking precision.

The difference between these implementation steps and those for Fig. 10 as described above lies in that: during training and VT tracking, DLL1 and the DLL2 of each data lane are adjusted, while in alternative solution 2 PI3 and the shared DLL2 of all data lanes are adjusted.

The above embodiment has the following four features:
1. No delay alignment is performed between the transmit data at the transmitting side and the feedforward clock fwdclk. This solves the problem in the prior art where fwdclk replicates the txclk clock tree;
2. The receiving side does not need to compensate for the delay of the sampling clock tree in the data path, and the delay of the sampling clock tree does not need to be within 0.5 UI. This solves the problem in the prior art that the data path needs to compensate for sampling clock tree delay, without an operation of back-end optimization of the clock tree delay;
3. The entire data path and clock path are aligned by using the method that the delays of the transmit clock tree at the transmitting side and the sampling clock tree at the receiving side offset each other. The specific implementation is: performing phase detection on the TRACK data (carrying the clock signal) and the sampling clock fwdclk at the receiving side (or an alternative solution: separately phase-locking the transmit clock tree at the transmitting side and the sampling clock tree at the receiving side, generally locking them to 2 UI or 4 UI, depending on the clock tree delay and the UI value), so as to ensure that the delays of the two are the same. Compared with the prior art, this phase-locking method can achieve higher precision. Furthermore, the total path delay does not increase, and the jitter impact caused by the change of the temperature and voltage is relatively less;
4. There is a voltage-temperature drift tracking mechanism. Before operation, the sampling clock is trained and aligned at the center of the TRACK data to ensure that the sampled TRACK data is right. During operation, the phase is shifted by 90 degrees via PI3 on the TRACK to the right boundary of the TRACK data, ensuring that during operation the sampled even and odd bits cannot obtain stable data (the data transmitted by the transmitting side on the TRACK lane is fixed pattern data of 1010...). When the sampled even/odd bits become stably 1 or 0, it indicates that the sampling clock delay drifts, and the PI connected to the sampling clock tree can be adjusted to compensate for the drift delay.

The embodiments of the present disclosure utilize the characteristic that the delays of the transmit clock tree on the data path and the sampling clock tree on the clock path are similar and can offset each other. Instead of aligning the data clock edges of each of the transmitting side and the receiving side, the entire data path and clock path of both the transmitting side and the receiving side are taken into consideration together, and the delays are made equal through PD locking. This reduces various circuits such as clock tree replication circuits and clock tree delay compensation circuits. Specifically, there are the following advantages:
1. It avoids adding clock tree delay compensation circuits in the data path, does not increase the total delay, results in smaller jitter caused by temperature and voltage changes, and eliminates deviation between the compensation circuit and the clock tree., especially for high-speed data signals (current analogue simulation shows that above 24 Gbps, adding a delay of about 100 ps to the data path will cause signal degradation, causing the sampling eye pattern closed);
2. The overall PD phase locking covers the complete data path and clock path, enabling smaller deviation. Alternatively, in the alternative embodiment, the transmit clock tree and the receive clock tree are separately phase-locked, covering the maximum delay part which is also the main portion affected by the VT changes, thus resulting in smaller overall delay and smaller clock-data deviation.
3. The back-end implementation is simpler. There is no need to add a clock tree compensation circuit on the data path.

The above are only the preferred embodiments of the present disclosure and are not intended to limit the present disclosure. For those skilled in the art, the present disclosure may have various modifications and variations. Any modifications, equivalent replacements, improvements and the like made within the principle of the disclosure shall fall within the scope of protection of the present disclosure.

## Claims

1. A clock calibration circuit, comprising:
a first sampling circuit; and a second sampling circuit connected in series with the first sampling circuit;
wherein the first sampling circuit comprises: a phase-locked loop (PLL); a first duty cycle calibrator (DCC) connected in series with the PLL; a first phase interpolator (PI) connected in series with the first DCC; a first clock tree connected in series with the first PI; a first data serializer connected in series with the first clock tree; a first transmit driver connected in series with the first data serializer; a second data serializer connected in series with the first DCC; and a second transmit driver connected in series with the second data serializer;
wherein the PLL is configured to output a clock signal to drive the first data serializer to transmit data to be transmitted to the first transmit driver, and drive the second data serializer to transmit a feedforward clock signal to the second transmit driver; and
the second transmit driver is configured to transmit the feedforward clock signal to a first receive driver in the second sampling circuit, to determine the feedforward clock signal as a sampling clock for the second sampling circuit.

2. The clock calibration circuit according to claim 1, wherein the second sampling circuit comprises:
a second receive driver connected in series with the first transmit driver and configured to receive the data to be transmitted from the first transmit driver, and transmit the data to be transmitted to a first data deserializer through a small delay buffer connected in series with the second receive driver, wherein the first data deserializer is connected in series with the small delay buffer.

3. The clock calibration circuit according to claim 2, wherein the second sampling circuit further comprises: a DCC buffer;
wherein the DCC buffer is connected in series with the second receive driver and the small delay buffer respectively, and is configured to compensate for an intrinsic delay of the first DCC.

4. The clock calibration circuit according to claim 2, wherein the second sampling circuit comprises:
a second DCC connected in series with the first receive driver; a second PI connected in series with the second DCC; a second clock tree connected in series with the second PI; and the first data deserializer and a second data deserializer both connected in series with the second clock tree;
wherein the first receive driver is configured to transmit the feedforward clock signal to the first data deserializer and the second data deserializer respectively through the second DCC, the second PI and the second clock tree, so as to determine the feedforward clock signal as a sampling clock for the first data deserializer and the second data deserializer.

5. The clock calibration circuit according to claim 4, wherein the second sampling circuit comprises: a PI buffer;
wherein the PI buffer is connected in series with the second clock tree and the first data deserializer respectively, and is configured to compensate for an intrinsic delay of the second PI.

6. The clock calibration circuit according to claim 4, wherein the second sampling circuit comprises:
a third PI connected in series with the second clock tree, and a second data deserializer connected in series with the third PI;
wherein the third PI is configured to be set to a fixed phase shift after training of a plurality of data links and TRACK links is completed, wherein the plurality of the data links and the TRACK links correspond to different transmit drivers respectively.

7. The clock calibration circuit according to claim 4, wherein the first sampling circuit comprises:
a third PI, connected in series with the first clock tree and the first data serializer respectively, and configured to be set to a fixed phase shift after training of a plurality of data links and TRACK links is completed, wherein the plurality of the data links and the TRACK links correspond to different transmit drivers respectively.

8. The clock calibration circuit according to claim 4, wherein the second sampling circuit comprises:
a first data check module, connected in series with the first data deserializer and the second PI respectively, and configured to adjust a delay of the second PI during training of data links; and/or
a second data check module, connected in series with the second data deserializer and the second PI respectively, and configured to adjust a delay of the second PI during training of TRACK links.

9. The clock calibration circuit according to claim 4, wherein the second sampling circuit comprises: a first delay-locked loop (DLL) connected in series with the second clock tree and the first data deserializer respectively;
the second sampling circuit further comprises: a second DLL connected in series with the second clock tree and the second data deserializer respectively.

10. The clock calibration circuit according to claim 4, wherein the second sampling circuit comprises:
a third DLL, connected in series with the second DCC and the second PI respectively, and configured to perform delay processing on a plurality of data links and TRACK links, wherein the plurality of the data links and the TRACK links correspond to different transmit drivers respectively.

11. The clock calibration circuit according to any one of claims 1 to 10, wherein the first sampling circuit is a first die sampling circuit; the second sampling circuit is a second die sampling circuit.
